# EUROPÄISCHE PATENTSCHRIFT

(11) **EP 1 119 231 B1**
(45) Veröffentlichungstag und Bekanntmachung des Hinweises auf die Patenterteilung: **07.12.2005**
(21) Anmeldenummer: 01100599.8
(22) Anmeldetag: 10.01.2001
(51) Int. Cl.: H05K 9/00

(54) **Hochfrequenz-Leistungsverstärker**
High frequency power amplifier
Amplificateur de puissance hautes fréquences

(30) Priorität: 18.01.2000 DE 10001827
(43) Veröffentlichungstag der Anmeldung: 25.07.2001
(73) Patentinhaber: Rohde & Schwarz GmbH & Co. KG, 81671 München (DE)
(72) Erfinder: Hupfer, Konrad, 85435 Erding (DE)
(74) Vertreter: Körfer, Thomas

(56) Entgegenhaltungen:
- DE-A- 2 916 393
- DE-B- 1 135 959
- DE-U- 29 914 571
- US-A- 3 662 223
- US-A- 4 124 877

## Beschreibung

Die Erfindung betrifft einen Hochfrequenz-Leistungsverstärker laut Oberbegriff des Hauptanspruches.

Hochfrequenz-Leistungsverstärker dieser Art sind bekannt. Bei ihrem Einsatz im Labor oder bei sogenannten EMV-Untersuchungen kommt es oft vor, daß der Eingangsverstärkerstufe über die Eingangsbuchse eine zu hohe Steuerleistung von beispielsweise mehr als 100 mW zugeführt wird und dadurch die Eingangsverstärkerstufe nicht nur übersteuert, sondern deren empfindliche elektronische Bauteile wie Transistoren und dergleichen zerstört werden. Bei den bisher üblichen Leistungsverstärkern dieser Art ist die Eingangsverstärkerstufe meist auf der gleichen Platine wie die Leistungsverstärkerstufe ausgebildet und es muß daher das gesamte Gerät für eine teure Reparatur meist zum Hersteller eingeschickt werden, der dann die Eingangsverstärkerstufe ersetzt.

Es ist daher Aufgabe der Erfindung, eine Hochfrequenz-Leistungsverstärkerstufe dieser Art zu schaffen, bei der vom Benutzer selbst auf einfache Weise eine versehentlich durchgebrannte Eingangsverstärkerstufe ersetzt werden kann.

Diese Aufgabe wird ausgehend von einer Hochfrequenz-Leistungsverstärkerstufe laut Oberbegriff des Hauptanspruches durch dessen kennzeichnende Merkmale gelöst. Vorteilhafte Weiterbildungen ergeben sich aus den Unteransprüchen.

Wenn bei einem erfindungsgemäßen Leistungsverstärker durch unsachgemäße Behandlung im Labor oder bei anderen Untersuchungen die Eingangsverstärkerstufe durch zu hohe Steuerleistung zerstört wird, ist es nur erforderlich, die Eingangsbuchse vom Gerät zu lösen und zusammen mit der Eingangsverstärkerstufe aus dem Gerät auszubauen. Die Eingangsverstärkerstufe kann dann gegebenenfalls repariert werden, vorzugsweise wird sie jedoch durch eine Ersatz-Eingangsverstärkerstufe ersetzt, da solche Eingangsverstärkerstufen sehr preiswert aus nur wenigen elektronischen Bauelementen, beispielsweise zwei bis drei MMIC's und einigen Widerständen und Kondensatoren aufgebaut sein können. Eine solche Ersatz-Eingangsverstärkerstufe mit Eingangsbuchse kann vom Hersteller bereits dem Gerät mitgeliefert werden.

Die Erfindung wird im Folgenden anhand einer schematischen Zeichnung an einem Ausführungsbeispiel näher erläutert.

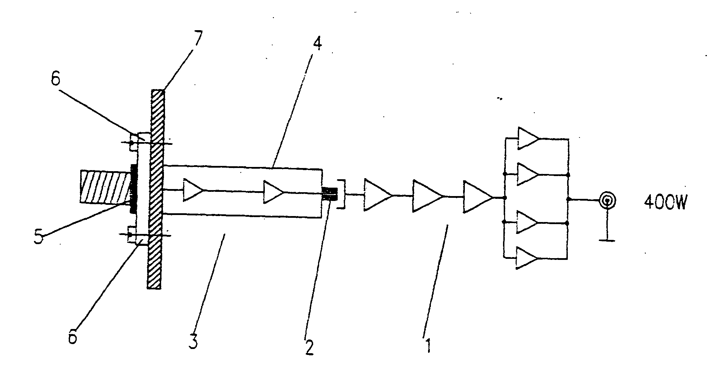

Die Figur zeigt einen Hochfrequenz-Leistungsverstärker mit einer nur schematisch angedeuteten Leistungsverstärkerstufe 1, die beispielsweise aus mehreren parallel geschalteten einzelnen Verstärkerstufen aufgebaut ist und eine Ausgangsleistung von beispielsweise 400 W liefert. Diese Leistungsverstärkerstufe 1 ist über eine lösbare Steckverbindung 2 mit einer Eingangsverstärkerstufe 3 verbunden, die in einem kleinen Gehäuse 4 eingebaut ist und beispielsweise aus zwei oder drei hintereinander geschalteten Transistorverstärkern besteht. Eingangsseitig ist diese Eingangsverstärkerstufe 3 mit einer Eingangsbuchse 5 verbunden, die in dem gezeigten Ausführungsbeispiel über Schrauben 6 lösbar an der Frontplatte 7 des nur bruchstückhaft dargestellten Gehäuses befestigt ist, in welchem Leistungsverstärkerstufe 1 und Eingangsverstärkerstufe 3, 4 angeordnet sind. Das Gehäuse 4 der Eingangsverstärkerstufe 3 ist unmittelbar mechanisch mit der Rückseite der Eingangsbuchse 5 verbunden und kann nach Lösen der Schrauben 6 zusammen mit der Buchse 5 von der Frontplatte 7 gelöst werden. Die lösbare Steckverbindung 2 am rückwärtigen Ende des Gehäuses 4 kann eine einfache Platinensteckverbindung sein, über die sowohl die Hochfrequenzverbindung als auch die Gleichstromverbindung für die Speisung der Eingangsverstärkerstufe hergestellt wird. Die lösbare Verbindung zwischen Eingangsbuchse 5 und Frontplatte 7 kann gegebenenfalls auch als Bajonettverbindung ausgebildet sein. Die Eingangsbuchse 5 ist von bekannter Bauart und beispielsweise als sogenannte N-Buchse ausgebildet.

## Patentansprüche

1. Hochfrequenz-Leistungsverstärker mit einer in einem Gehäuse (7) eingebauten Leistungsverstärkerstufe (1) sowie einer vorgeschalteten Eingangsverstärkerstufe (3), deren Eingang mit einer am Gehäuse (7) angebrachten Eingangsbuchse (5) verbunden ist,
**dadurch gekennzeichnet,**
**daß** die Eingangsverstärkerstufe (3, 4) mit der lösbar am Gehäuse (7) angebrachten Eingangsbuchse (5) mechanisch verbunden ist und über eine lösbare Steckverbindung (2) mit der Leistungsverstärkerstufe (1) elektrisch verbunden ist.

2. Hochfrequenz-Leistungsverstärker nach Anspruch 1,
**dadurch gekennzeichnet,**
**daß** die Eingangsverstärkerstufe (3, 4) preiswert aus nur wenigen elektronischen Bauteilen aufgebaut ist.

3. Hochfrequenz-Leistungsverstärker nach Anspruch 1 oder 2,
**dadurch gekennzeichnet,**
**daß** die Eingangsverstärkerstufe (3, 4) unmittelbar an der Rückseite der an der Frontplatte (7) des Gehäuses befestigten Eingangsbuchse (5) befestigt ist und an ihrem von der Eingangsbuchse (5) abgewandten Ende die mit der Leistungsverstärkerstufe (1) verbundene lösbare Steckverbindung (2) aufweist.

## Claims

1. High-frequency power amplifier with a power-amplifier stage (1) built into a housing (7) and with an input-amplifier stage (3) connected upstream, of which the input is connected to an input port (5) attached to the housing (7),
**characterised in that**
the input-amplifier stage (3, 4) is mechanically connected to the input port (5) mounted in a detachable manner in the housing (7) and electrically connected to the power-amplifier stage (1) via a detachable plug connection (2).

2. High-frequency power amplifier according to claim 1,
**characterised in that**
the input-amplifier stage (3, 4) is constructed in a cost-favourable manner from only a few electronic components.

3. High-frequency power amplifier according to claim 1 or 2,
**characterised in that**
the input-amplifier stage (3, 4) is attached directly to the rear side of the input port (5) mounted on the front panel (7) of the housing and provides the detachable plug connection (2) connected to the power-amplifier stage (1) at its end facing away from the input port (5).

## Revendications

1. Amplificateur de puissance haute fréquence avec un étage d'amplification de puissance (1) monté dans un boîtier (7), ainsi qu'avec un étage d'amplification d'entrée (3) monté en amont, dont l'entrée est reliée à une prise d'entrée (5) montée sur le boîtier (7),
**caractérisé en ce que**
l'étage d'amplification d'entrée (3, 4) est relié mécaniquement à la prise d'entrée (5) fixée de façon démontable sur le boîtier (7) et est relié électriquement par une connexion enfichable démontable (2) à l'étage d'amplification de puissance (1).

2. Amplificateur de puissance haute fréquence selon la revendication 1,
**caractérisé en ce que**
l'étage d'amplification d'entrée (3, 4) est assemblé de façon bon marché à partir d'un petit nombre seulement de composants électroniques.

3. Amplificateur de puissance haute fréquence selon la revendication 1 ou 2,
**caractérisé en ce que**
l'étage d'amplification d'entrée (3, 4) est fixé directement à la face arrière de la prise d'entrée (5) fixée sur la plaque frontale (7) du boîtier et comporte à son extrémité détournée de la prise d'entrée (5) la connexion enfichable démontable (2) reliée à l'étage d'amplification de puissance (1).
